# EUROPEAN PATENT APPLICATION

(11) **EP 4 113 127 A1**
(43) Date of publication of application: **04.01.2023**
(21) Application number: 21759559.4
(22) Date of filing: 13.02.2021
(51) Int. Cl.: G01R 1/067

(54) **CYLINDRICAL BODY, CONTACT TERMINAL, INSPECTION JIG, AND INSPECTION DEVICE**

(30) Priority: 26.02.2020 JP 2020031050
(71) Applicant: Nidec Read Corporation, Kyoto-shi, Kyoto, 615-0854 (JP)
(72) Inventor: OTA, Norihiro, Kyoto-shi, Kyoto 615-0854 (JP)
(74) Representative: Viering, Jentschura & Partner mbB Patent- und Rechtsanwälte
(86) International application number: PCT/JP2021/005378
(87) International publication number: WO 2021/172061

(57) **Abstract**

A tubular body extending in a longitudinal direction and having conductivity includes a first spring portion having a spiral notch formed in a peripheral surface of the tubular body, a second spring portion having a spiral notch formed in the peripheral surface of the tubular body and a first body portion sandwiched between the first spring portion and the second spring portion in the longitudinal direction. The distance from the longitudinal direction center of the tubular body to the longitudinal direction inner end of the first spring portion is equal to the distance from the longitudinal direction center to the longitudinal direction inner end of the second spring portion. The number of turns of the first spring portion is equal to the number of turns of the second spring portion. The first spring portion includes a first winding spring portion whose winding direction is a first direction and a second winding spring portion whose winding direction is a second direction opposite to the first direction.

## Description

### TECHNICAL FIELD

The present invention relates to a tubular body for assembling a contact terminal used for the inspection of an inspection target.

### BACKGROUND ART

Conventionally, a contact terminal to be brought into contact with an inspection target is known. Such a contact terminal is configured by inserting a rod-shaped member having conductivity into a tubular body on which a spring portion is formed (see, for example, Patent Literature 1.).

### CITATIONS LIST

### PATENT LITERATURE

Patent Literature 1: JP 2019-15542 A

### SUMMARY OF INVENTION

### TECHNICAL PROBLEMS

In this case, it is desired to improve the assemblability when a contact terminal is assembled by inserting a rod-shaped member into the tubular body on which a spring portion like that described above is formed.

In view of the above circumstances, an object of the present invention is to provide a tubular body that implements a contact terminal capable of controlling the amount of turning of a conductor and improving the assemblability.

### SOLUTIONS TO PROBLEMS

An exemplary tubular body according to the present invention extends in the longitudinal direction and has conductivity. The tubular body includes a first spring portion having a spiral notch formed in the peripheral surface of the tubular body, a second spring portion having a spiral notch formed in the peripheral surface of the tubular body, and a first body portion sandwiched between the first spring portion and the second spring portion in the longitudinal direction.

The distance from the longitudinal direction center of the tubular body to the longitudinal direction inner end of the first spring portion is equal to the distance from the longitudinal direction center to the longitudinal direction inner end of the second spring portion. The number of turns of the first spring portion is equal to the number of turns of the second spring portion. The first spring portion has a first winding spring portion whose winding direction is a first direction and a second winding spring portion whose winding direction is a second direction opposite to the first direction.

### ADVANTAGEOUS EFFECTS OF INVENTION

According to the exemplary tubular body of the present invention, it is possible to control the amount of turning of the conductor and to implement a contact terminal capable of improving the assemblability of the contact terminal.

### BRIEF DESCRIPTION OF DRAWINGS

FIG. 1 is a schematic diagram illustrating an overall configuration of an inspection apparatus according to an exemplary embodiment of the present invention.
FIG. 2 is a side view illustrating a contact terminal according to an exemplary embodiment of the present invention.
FIG. 3 is a side view illustrating a tubular body included in the contact terminal illustrated in FIG. 2.
FIG. 4 is an enlarged view of a part of the configuration in FIG. 1.
FIG. 5 is a side view illustrating an example of change in the design of the tubular body illustrated in FIG. 3.
FIG. 6 is a side view illustrating a tubular body according to a first comparative example.
FIG. 7 is a side view illustrating a tubular body according to a second comparative example.
FIG. 8 is an enlarged view mainly showing the boundary between a first winding spring portion and a second winding spring portion.
FIG. 9 is a side view illustrating a tubular body according to a modification of the present invention.

### DESCRIPTION OF EMBODIMENT

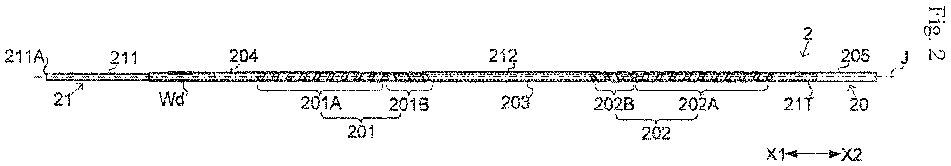

Hereinafter, exemplary embodiments of the present invention will be described with reference to the drawings. In the following, a direction parallel to a central axis J (see FIG. 2) of a contact terminal is defined as an "axial direction". In the drawings, "X1" represents one side in the axial direction and "X2" represents the other side in the axial direction. In addition, a direction about the central axis J will be referred to as a "circumferential direction".

### <1. Overall configuration of inspection apparatus>

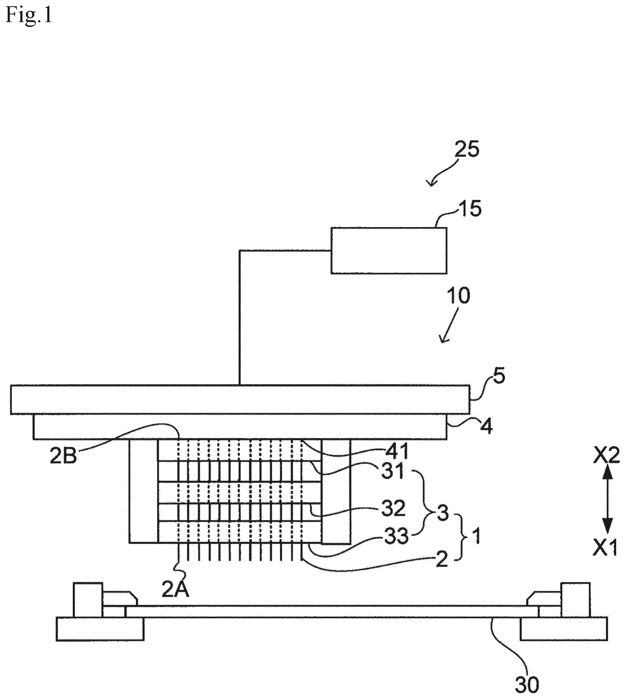

An overall configuration of an inspection apparatus 25 according to an exemplary embodiment of the present invention will be described with reference to FIG. 1. Referring to FIG. 1, a contact terminal 2 is assembled to the inspection apparatus 25 such that the one axial direction X1 side is the lower side.

The inspection apparatus 25 illustrated in FIG. 1 electrically inspects an inspection target 30. The inspection apparatus 25 includes an inspection jig 10 and an inspection processing unit 15. The inspection jig 10 is configured as, for example, a so-called probe card.

The inspection target 30 is, for example, a semiconductor wafer in which a plurality of circuits is formed on a semiconductor substrate such as silicon. The semiconductor wafer is diced to be divided into semiconductor chips having the individual circuits. In addition to the semiconductor wafer, the inspection target 30 can be, for example, an electronic component such as a semiconductor chip, a chip size package (CSP), a wafer level package (WLP), a fan out wafer level package (FOWLP), or a semiconductor element.

In addition, the inspection target 30 may be a substrate. In this case, the inspection target 30 may be, for example, a board such as a printed circuit board, a glass epoxy board, a flexible board, a ceramic multilayer circuit board, a package board for a semiconductor package, an interposer board, or a film carrier. The inspection target 30 may alternatively be an electrode plate for a display such as a liquid crystal display, an electroluminescence (EL) display, or a touch panel display, or an electrode plate for a touch panel.

The inspection target 30 may alternatively be a product obtained by packaging technology called embedded multi-die interconnect bridge (EMIB). According to EMIB, a small silicon substrate called a silicon bridge is embedded in a package resin board, and fine wires are formed on a surface of the silicon bridge in high density, so that adjacent silicon dies are mounted on the package resin board in proximity to each other.

As illustrated in FIG. 1, the inspection jig 10 includes a probe head 1, a pitch conversion unit 4, and a connection plate 5. The probe head 1 includes the contact terminal (probe) 2 and a support member 3.

The support member 3 supports a plurality of contact terminals 2 each formed in a rod shape. That is, the inspection jig 10 includes the plurality of contact terminals 2 and the support member 3 that supports the plurality of contact terminals 2.

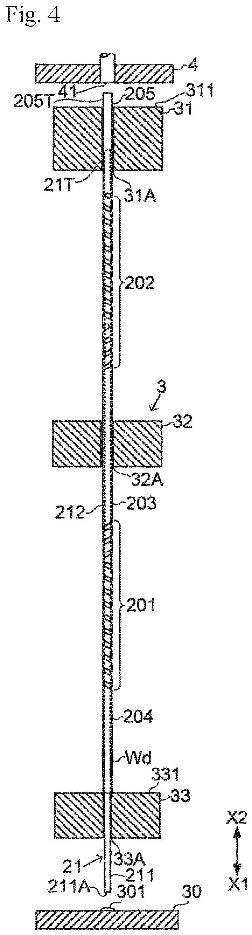

The pitch conversion unit 4 is disposed above the support member 3 and fixed to the support member 3. The contact terminal 2 has one end portion 2A on the one axial direction X1 side and the other end portion 2B on the other axial direction X2 side. The other end portion 2B is connected to each of first electrodes 41 (see FIG. 4) provided at the lower end portion of the pitch conversion unit 4.

Each of the first electrodes 41 is electrically connected to each of the second electrodes (not illustrated) formed at the upper end portion of the pitch conversion unit 4 via a wiring portion (not illustrated) formed inside the pitch conversion unit 4. The pitch conversion unit 4 converts a first pitch between the contact terminals 2 into a second pitch between the second electrodes. The second pitch is longer than the first pitch. The pitch conversion unit 4 is formed of, for example, a multi-layer wiring substrate such as a multi-layer organic (MLO) or a multi-layer ceramic (MLC).

The connection plate 5 is configured such that the pitch conversion unit 4 is detachable. A plurality of electrodes (not illustrated) connected to the second electrode are formed on the connection plate 5. Each of the electrodes of the connection plate 5 is electrically connected to the inspection processing unit 15 by, for example, a cable, a connection terminal, or the like (not illustrated).

The inspection processing unit 15 includes, for example, a power supply circuit, a voltmeter, an ammeter, and a microcomputer. The inspection processing unit 15 controls a drive mechanism (not illustrated) to move the inspection jig 10.

In a case where the inspection target 30 is, for example, a semiconductor wafer, inspection points such as pads or bumps are set for each circuit corresponding to an individual semiconductor chip to be obtained by dicing the inspection target 30. The inspection processing unit 15 defines a certain region of the plurality of circuits on the inspection target 30 as an inspection region, and moves the inspection jig 10 to a position at which the contact terminals 2 located above are opposite the inspection points located below in the inspection region. At this time, the one end portions 2A of the contact terminals 2 of the inspection jig 10 are directed toward the inspection target 30.

Then, the inspection processing unit 15 moves the inspection jig 10 downward to bring the contact terminal 2 into contact with each inspection point in the inspection region. In this manner, the inspection points and the inspection processing unit 15 are electrically connected.

The inspection processing unit 15 supplies a current or a voltage for inspection to each inspection point of the inspection target 30 via each contact terminal 2 in the above-described state, and executes inspection of the inspection target 30 such as disconnection or short circuit of a circuit pattern based on a voltage signal or a current signal obtained from each contact terminal 2. Alternatively, the inspection processing unit 15 may measure an impedance of the inspection target 30 based on the voltage signal or the current signal obtained from each contact terminal 2 by supplying AC current or voltage to the inspection points. Alternatively, the inspection processing unit 15 may supply various test patterns to each inspection point to check whether a desired circuit operation has been performed.

That is, the inspection apparatus 25 includes the inspection jig 10 and the inspection processing unit 15 that performs inspection of the inspection target 30 based on the electrical signal obtained by bringing the contact terminal 2 into contact with the inspection point provided in the inspection target 30.

When the inspection in the inspection region of the inspection target 30 is completed, the inspection processing unit 15 moves the inspection jig 10 upward, translates the inspection jig 10 to a position corresponding to the new inspection region, moves the inspection jig 10 downward, and brings the contact terminal 2 into contact with each inspection point in the new inspection region to perform the inspection. In this manner, the entire inspection target 30 is inspected by performing the inspection while sequentially changing the inspection region.

The position of the inspection jig 10 may be fixed, and the inspection target 30 may be moved with respect to the inspection jig 10.

### <2. Configuration of contact terminal>

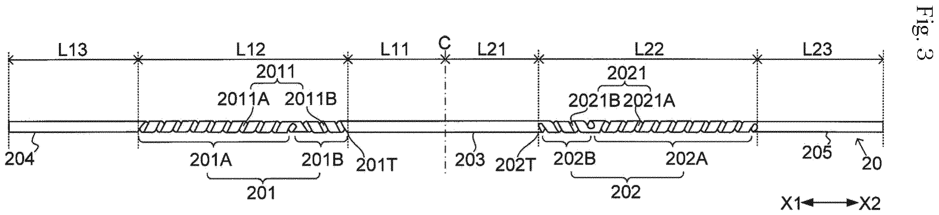

Hereinafter, the configuration of the contact terminal 2 will be described in more detail. FIG. 2 illustrates a case where no load is applied to the contact terminal 2 and a first spring portion 201 and a second spring portion 202 are in a natural length state. FIG. 3 is a view illustrating the state of the tubular body 20 alone before the conductor 21 is assembled to the tubular body 20 to assemble the contact terminal 2.

The contact terminal 2 includes the tubular body 20 extending in the axial direction of the contact terminal 2 and having conductivity and the rod-shaped conductor (plunger) 21 having conductivity. The conductor 21 is formed of, for example, a conductive material such as a palladium alloy. The tubular body 20 extends in the longitudinal direction. The longitudinal direction coincides with the axial direction of the contact terminal 2.

The tubular body 20 has a cylindrical shape and is formed from, for example, a nickel or nickel-alloy tube having an outer diameter of about 25 µm to 300 µm and an inner diameter of about 10 µm to 250 µm. Preferably, the tubular body 20 has, on its inner peripheral surface, a plating layer such as a gold plating layer. In addition, the tubular body 20 may have an outer peripheral surface coated with an insulation coating as necessary.

The tubular body 20 includes a first spring portion 201 in which a spiral notch 2011 (FIG. 3) is formed on a peripheral surface of the tubular body 20 and a second spring portion 202 in which a spiral notch 2021 is formed on a peripheral surface of the tubular body 20. The second spring portion 202 is disposed on the other axial direction X2 side of the first spring portion 201.

The tubular body 20 has a first body portion 203 disposed to be sandwiched between the first spring portion 201 and the second spring portion 202 in the axial direction (longitudinal direction). The first body portion 203 is connected to the first spring portion 201 and the second spring portion 202. The first body portion 203 has a tubular shape that is not formed in a spiral shape.

The tubular body 20 includes a second body portion 204 connected to one side X1 in the axial direction of the first spring portion 201 and a third body portion 205 connected to the other side X2 in the axial direction of the second spring portion 202. The second body portion 204 and a third body portion 205 have a tubular shape that is not formed in a spiral shape. That is, the second body portion 204 is disposed on the opposite side the first spring portion 201 to the first body portion 203.

In order to produce a tubular body having such a spiral body, for example, a gold plating layer is formed by plating on the outer periphery of a core material, and then a nickel electroforming layer is formed by electroforming on the outer periphery of the formed gold plating layer. A resist layer is formed on an outer periphery of the nickel electroforming layer, and then is exposed with a laser, so that the resist layer is partially removed in a spiral shape. Etching is performed using the resist layer as a masking material to remove the nickel electroforming layer at a place where the resist layer has been spirally removed. Then, after the resist layer is removed, the gold plating layer at the place where the nickel electroforming layer is spirally removed is removed, and the core material is removed while the gold plating layer is left on the inner periphery of the nickel electroforming layer to form a tubular body.

The conductor 21 includes a protruding portion 211 that protrudes from the tubular body 20 to the one axial direction X1 side and an insertion portion 212 that is connected to the other axial direction X2 side of the protruding portion 211 and disposed inside the tubular body 20.

The protruding portion 211 has a distal end portion 211A on the one axial direction X1 side. The distal end portion 211A is in contact with an inspection point of the inspection target 30 as described later. That is, the conductor 21 can come into contact with the inspection target 30.

In the example of FIG. 2, the distal end portion 211A has a cylindrical shape, but is not limited thereto, and may have, for example, a conical shape, a truncated conical shape, a hemispherical shape, or the like.

When assembling the contact terminal 2 illustrated in FIG. 2, another axial end portion 21T (FIG. 2) of the conductor 21 is inserted into the second body portion 204 of the tubular body 20 illustrated in FIG. 3, and the conductor 21 is pushed toward the other axial direction X2 side until the other axial direction X2 side end portion 21T is located inside the third body portion 205 as illustrated in FIG. 2.

Then, a part of the portion of the insertion portion 212 which is disposed inside the second body portion 204 is fixed to the second body portion 204 by welding. FIG. 2 illustrates a welded portion Wd which is a portion fixed by welding. In the contact terminal 2, the outer diameter of the welded portion Wd is largest. In this manner, the conductor 21 is fixed to the second body portion 204 of the tubular body 20. The method of fixing the conductor 21 to the tubular body 20 is not limited to welding and may be press fitting, caulking, or the like.

Details of the configuration of the tubular body 20 will be described later.

FIG. 4 is a diagram illustrating a state in which the contact terminal 2 is supported by the support member 3. As illustrated in FIG. 4, the support member 3 includes an upper support body 31, an intermediate support body 32, and a lower support body 33. Here, a configuration in which the contact terminal 2 is supported by the support member 3 will be described.

The lower support body 33 has a support hole 33A which is a through hole extending through the thickness direction. The diameter of the support hole 33A is smaller than the outer diameter of the second body portion 204 and larger than the inner diameter of the second body portion 204. As a result, the protruding portion 211 can be inserted into the support hole 33A, and the second body portion 204 comes into contact with an upper surface 331 of the lower support body 33, thereby preventing the contact terminal 2 from falling off.

The intermediate support body 32 is disposed above the lower support body 33 and has a support hole 32A which is a through hole coaxial with the support hole 33A. The diameter of the support hole 32A is slightly larger than the outer diameter of the welded portion Wd. As a result, the first body portion 203 can be inserted into the support hole 32A.

The upper support body 31 is disposed above the intermediate support body 32 and has a support hole 31A which is a through hole coaxial with the support hole 32A. The diameter of the support hole 31A is slightly larger than the outer diameter of the welded portion Wd. As a result, the third body portion 205 can be inserted into the support hole 31A. The other axial end portion 21T of the conductor 21 is accommodated in the support hole 31A.

In supporting each contact terminal 2 with the support member 3, the protruding portion 211 is inserted from above into the support hole 31A, the support hole 32A, and the support hole 33A in this order. As illustrated in FIG. 4, in a state where the contact terminal 2 is supported by the support member 3, the other axial end portion 205T of the third body portion 205 protrudes upward from the support hole 31A.

Then, the upper surface 311 of the upper support body 31 is pressed against the lower surface of the pitch conversion unit 4 while the other axial end portion 205T of the third body portion 205 is brought into contact with the first electrode 41 exposed to the lower surface of the pitch conversion unit 4. Thus, the support member 3 is fixed to the pitch conversion unit 4. At this time, the first spring portion 201 and the second spring portion 202 are compressed in the axial direction. As a result, the other axial end portion 205T is pressed against the first electrode 41 by the elastic force of the spring portions 201 and 202, and the other axial end portion 205T and the first electrode 41 are held in a stable conductive contact state.

Further, when the inspection target 30 is inspected, the distal end portion 211A of the protruding portion 211 is brought into contact with an inspection point 301 of the inspection target 30. At this time, a force toward the other axial direction X2 side is applied to the distal end portion 211A, and the first spring portion 201 and the second spring portion 202 are compressed in the axial direction. As a result, the distal end portion 211A is pressed against the inspection point 301 by the elastic force of the spring portions 201 and 202, and the distal end portion 211A and the inspection point 301 are held in a stable conductive contact state. At this time, as will be described later, the circumferential turning of the tubular body 20 or eventually the conductor 21 is controlled by the winding direction and the number of turns of the winding spring portion in the spring portions 201 and 202.

Since the other axial end portion 205T is pressed against the first electrode 41 in advance, the other axial end portion 205T functions as a fixed end. The distal end portion 211A turns in the circumferential direction. For this reason, the distal end portion 211A scrapes the oxide film on the surface of the inspection point 301 and achieves a stable electrical contact state. As will be described later, since the turning of a first winding spring portion 201A and a third winding spring portion 202A is alleviated by partially canceling the turning of a second winding spring portion 201B and a fourth winding spring portion 202B, the burden on the inspection target 30 is reduced.

### <3. Characteristics of tubular body>

The characteristics of the configuration of the tubular body 20 will be described next in detail.

As illustrated in FIG. 3, a distance L11 from a center C in the longitudinal direction of the tubular body 20 to a longitudinal direction inner end 201T of the first spring portion 201 is equal to a distance L21 from the center C in the longitudinal direction to a longitudinal direction inner end 202T of the second spring portion 202.

The first spring portion 201 includes the first winding spring portion 201A and the second winding spring portion 201B. The notch 2011 has a first spiral notch 2011A and a second spiral notch 2011B. The first winding spring portion 201A has a first spiral notch 2011A. The second winding spring portion 201B has a second spiral notch 2011B.

The second winding spring portion 201B is disposed on the other axial direction X2 side of the first winding spring portion 201A. The first winding spring portion 201A and the second winding spring portion 201B are almost connected to each other. However, as will be described later, the first winding spring portion 201A and the second winding spring portion 201B are not connected to each other in a strict sense, and a constituent portion including a winding spring portion having such an arrangement is also included in the "spring portion ".

In this case, the winding direction of the winding spring portion is a rotation direction when the winding spring portion is directed toward the winding spring portion itself along the winding spring portion when the winding spring portion is viewed in the axial direction (longitudinal direction). That is, as illustrated in FIG. 3, the winding direction of the first winding spring portion 201A is a clockwise direction (first direction), and the winding direction of the second winding spring portion 201B is a counterclockwise direction (second direction). That is, the first spring portion 201 has a first winding spring portion 201A whose winding direction is the first direction and a second winding spring portion 201B whose winding direction is the second direction opposite to the first direction.

The second spring portion 202 includes a third winding spring portion 202A and a fourth winding spring portion 202B. The third winding spring portion 202A has a third spiral notch 2021A. The fourth winding spring portion 202B has a fourth spiral notch 2021B. The notch 2021 has a third spiral notch 2021A and a fourth spiral notch 2021B.

The third winding spring portion 202A is disposed on the other axial direction X2 side of the fourth winding spring portion 202B. The third winding spring portion 202A and the fourth winding spring portion 202B are almost connected to each other. However, as will be described later, in a precise sense, the third winding spring portion 202A and the fourth winding spring portion 202B are not connected to each other.

The pitches of the first winding spring portion 201A, the second winding spring portion 201B, the third winding spring portion 202A, and the fourth winding spring portion 202B are the same.

As illustrated in FIG. 3, the winding direction of the third winding spring portion 202A is a clockwise direction (first direction), and the winding direction of the fourth winding spring portion 202B is a counterclockwise direction (second direction). That is, the second spring portion 202 has the third winding spring portion 202A whose winding direction is the first direction and the fourth winding spring portion 202B whose winding direction is the second direction.

In the configuration illustrated in FIG. 3, the number of turns of the first winding spring portion 201A is 9.5, and the number of turns of the second winding spring portion 201B is 3. The number of turns of the third winding spring portion 202A is 9.5, and the number of turns of the fourth winding spring portion 202B is 3. Therefore, the sum of the number of turns of the first winding spring portion 201A and the number of turns of the second winding spring portion 201B and the sum of the number of turns of the third winding spring portion 202A and the number of turns of the fourth winding spring portion 202B both coincide with each other at 12.5. That is, the number of turns of the first spring portion 201 is equal to the number of turns of the second spring portion 202.

In this case, since the pitches of the first winding spring portion 201A, the second winding spring portion 201B, the third winding spring portion 202A, and the fourth winding spring portion 202B are the same, the difference between a longitudinal length L12 of the first spring portion 201 and a longitudinal length L22 of the second spring portion 202 can be reduced. In this case, since distances L11 and L21 are equal as described above, the difference between a longitudinal length L13 of the second body portion 204 and a longitudinal length L23 of the third body portion 205 becomes small.

Therefore, unlike FIG. 2, it is also possible for an operator who assembles the contact terminal 2 to assemble the contact terminal 2 by inserting the other axial end portion 21T of the conductor 21 into the tubular body 20 from the second body portion 205. In this case, a part of the portion of the conductor 21 which is accommodated in the second body portion 205 is fixed to the second body portion 205 by welding. Then, as in FIG. 4, even if the contact terminal 2 is supported by the support member 3 with the protruding portion 211 of the conductor 21 facing downward, the spring portions 201 and 202 do not interfere with the intermediate support body 32, and the first body portion 32A can be supported by the intermediate support body 32. That is, the operator does not need to check the orientation of the tubular body 20 when assembling the contact terminal 2, and the assemblability of the contact terminal 2 is improved.

The sum of the number of turns of the first winding spring portion 201A and the number of turns of the third winding spring portion 202A is 9.5 + 9.5 = 19. The sum of the number of turns of the second winding spring portion 201B and the number of turns of the fourth winding spring portion 202B is 3 + 3 = 6. That is, the total number of turns of the winding spring portions whose winding direction is the first direction is 19, and the total number of turns of the winding spring portions whose winding direction is the second direction is 6. When an axial stroke is given to the tubular body 20, the tubular body 20 turns with the amount of turning obtained by multiplying the amount of turning corresponding to the stroke of the winding spring of one turn by 19 -6 = 13, which is the difference in the total number of turns. Since the tubular body 20 turns a winding direction corresponding to a larger one of the total number of turns of the winding spring portion in the first direction and the total number of turns of the winding spring portion in the second direction, the tubular body turns in the first direction in this case.

As described above, since the first spring portion 201 includes the first winding spring portion 201A whose winding direction is the first direction and the second winding spring portion 201B whose winding direction is the second direction, the amount of turning of the tubular body 20 or eventually the conductor 21 can be controlled. As described above, the sum of the number of turns of the first winding spring portion 201A and the number of turns of the third winding spring portion 202A (19 in the above example) is not equal to the sum of the number of turns of the second winding spring portion 201B and the number of turns of the fourth winding spring portion 202B (6 in the above example). This makes it possible to perform control to turn the tubular body 20.

By equalizing the sum of the number of turns of the first winding spring portion 201A and the number of turns of the third winding spring portion 202A and the sum of the number of turns of the second winding spring portion 201B and the number of turns of the fourth winding spring portion 202B, turning by the winding spring portion in the first direction and turning by the winding spring portion in the second direction may be canceled to prevent the tubular body 20 from turning. For example, the number of turns of the first winding spring portion 201A may be 9.5, the number of turns of the second winding spring portion 201B may be 3, the number of turns of the third winding spring portion 202A may be 3, and the number of turns of the fourth winding spring portion 202B may be 9.5.

In addition, since the second spring portion 202 includes the third winding spring portion 202A whose winding direction is the first direction and the fourth winding spring portion 202B whose winding direction is the second direction, the turning of the tubular body 20 can be controlled together with the first winding spring portion 201A and the second winding spring portion 201B.

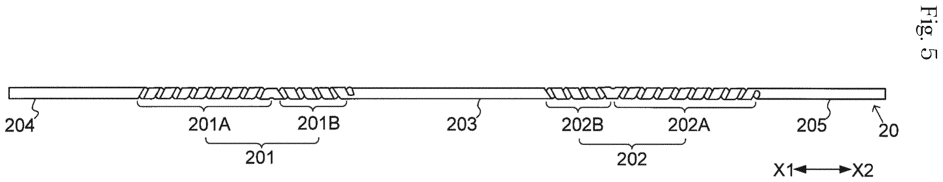

In this case, FIG. 5 illustrates an example in which the tubular body 20 illustrated in FIG. 3 is modified in design. In the tubular body 20 illustrated in FIG. 5, each of the numbers of turns of the first winding spring portion 201A, the second winding spring portion 201B, the third winding spring portion 202A, and the fourth winding spring portion 202B is changed without changing each of the numbers of turns of the first spring portion 201 and the second spring portion 202 from that in FIG. 3.

More specifically, referring to FIG. 5, the number of turns of the first winding spring portion 201A is 8.25, the number of turns of the second winding spring portion 201B is 4.25, the number of turns of the third winding spring portion 202A is 8.25, the number of turns of the fourth winding spring portion 202B is 4.25, the number of turns of the first spring portion 201 is 12.5, and the number of turns of the second spring portion 202 is 12.5.

In this case, the sum of the number of turns of the first winding spring portion 201A and the number of turns of the third winding spring portion 202A is 8.25 + 8.25 = 16.5. The sum of the number of turns of the second winding spring portion 201B and the number of turns of the fourth winding spring portion 202B is 4.25 + 4.25 = 8.5. That is, the total number of turns of the winding spring portions whose winding direction is the first direction is 16.5, and the total number of turns of the winding spring portions whose winding direction is the second direction is 8.5. When an axial stroke is given to the tubular body 20, the tubular body 20 turns with the amount of turning obtained by multiplying the amount of turning corresponding to the stroke of the winding spring of one turn by 16.5 -8.5 = 8, which is the difference in the total number of turns.

As described above, in the tubular body 20 after the change in design illustrated in FIG. 5, the longitudinal direction length L12 of the first spring portion 201 and the longitudinal direction length L22 of the second spring portion 202 are not changed, so that it is not necessary to change the position of the intermediate support body 32 when the contact terminal 2 assembled from the tubular body 20 illustrated in FIG. 5 is used as the support body 3. That is, even if the design of the amount of turning of the tubular body 20 is changed, it is not necessary to change the structure of the support member 3.

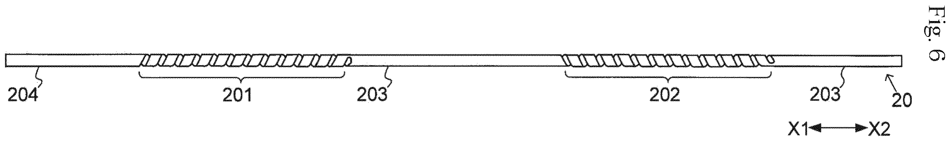

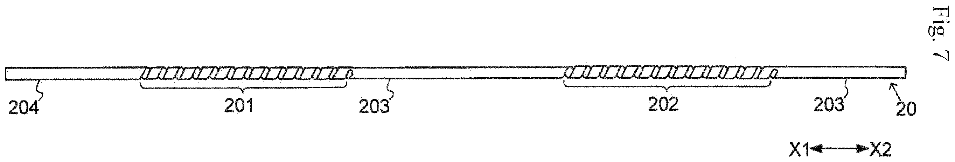

FIGS. 6 and 7 show the configuration of the tubular body 20 according to a comparative example for comparison with the present embodiment. In the tubular body 20 illustrated in FIG. 6, the first spring portion 201 is formed only of a winding spring portion whose winding direction is the first direction, and the second spring portion 202 is formed only of a winding spring portion whose winding direction is the second direction. The number of turns of the first spring portion 201 and the number of turns of the second spring portion 202 coincide with each other at 12.5. Therefore, in this case, when an axial stroke is given to the tubular body 20, the turning by the first spring portion 201 and the turning by the second spring portion 202 are canceled, and turning does not occur in the tubular body 20.

In the tubular body 20 illustrated in FIG. 7, the first spring portion 201 is formed only of a winding spring portion whose winding direction is the first direction, and the second spring portion 202 is formed only of a winding spring portion whose winding direction is the first direction. The number of turns of the first spring portion 201 and the number of turns of the second spring portion 202 coincide with each other at 12.5. Therefore, in this case, when an axial stroke axial is given to the tubular body 20, the tubular body 20 turns by the amount of turning obtained by multiplying the amount of turning according to the stroke of the winding spring of one turn by 12.5 + 12.5 = 25.

As described above, if only the tubular body 20 illustrated in FIGS. 6 and 7 can be prepared, only the presence or absence of turning of the tubular body 20 can be selected. In contrast to this, the amount of turning can be adjusted if the tubular body 20 according to the present embodiment as illustrated in FIG. 3 or 5 is used. In the example in FIG. 3, the amount of turning can be adjusted to about 1/2 that of the tubular body 20 illustrated in FIG. 7, and in the example in FIG. 5, the amount of turning can be adjusted to about 1/3 that of the tubular body 20 illustrated in FIG. 7.

In addition, for example, the amount of turning can be adjusted by giving a difference between the numbers of turns of the first spring portion 201 and the second spring portion 202 whose winding directions are opposite to each other as illustrated in FIG. 6. However, in this case, there is a difference between the longitudinal lengths of the first spring portion 201 and the second spring portion 202. As a result, a direction in which the conductor 21 is inserted into the tubular body 20 is determined, and confirmation by an operator is required. In addition, it is necessary to change the position of the intermediate support body 32 every time the design for the amount of turning is changed.

### <4. Boundary between winding spring portions>

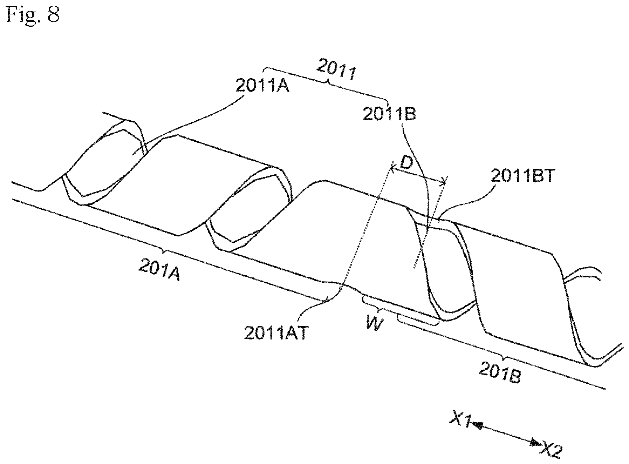

The configuration of the boundary between the first winding spring portion 201A and the second winding spring portion 201B in the tubular body 20 (for example, FIGS. 3 and 5) according to the present embodiment will be described next. As illustrated in FIG. 8, at the boundary between the first winding spring portion 201A and the second winding spring portion 201B, a longitudinal direction inner end portion 2011AT of a first spiral notch 2011A and a longitudinal direction outer end portion 2011BT of a second spiral notch 2011BT are disposed at positions separated by 180° around the axial direction (longitudinal direction).

As a result, as illustrated in FIG. 8, the longitudinal direction inner end portion 2011AT and the longitudinal direction outer end portion 2011BT can be separated by the distance D in the axial direction. The distance D is, for example, 50 µm. As a result, as illustrated in FIG. 8, a band width W from the longitudinal direction inner end portion 2011AT to the second spiral notch 2011B can be secured. Therefore, when a load is applied to the tubular body 20, the stress is dispersed by the band width W. That is, the strength of the tubular body 20 can be improved.

In the configuration in which the distance D is secured as described above, the first winding spring portion 201A and the second winding spring portion 201B are not connected to each other in a strict sense. Note that the longitudinal direction inner end portion 2011AT and the longitudinal direction outer end portion 2011BT may be connected. That is, in this case, the spiral notch 2011 is formed in a single stroke manner, and the first winding spring portion 201A and the second winding spring portion 201B are connected.

The configuration at the boundary between the winding spring portions illustrated in FIG. 8 is the same as the configuration at the boundary between the third winding spring portion 202A and the fourth winding spring portion 202B. Therefore, the longitudinal direction length L12 of the first spring portion 201 is the length obtained by adding the distance D to the sum of the longitudinal direction length of the first winding spring portion 201A and the longitudinal direction length of the second winding spring portion 201B, and the longitudinal direction length L22 of the second spring portion 202 is the length obtained by adding the distance D to the sum of the longitudinal direction length of the third winding spring portion 202A and the longitudinal direction length of the fourth winding spring portion 202B. Since the number of turns of the first spring portion 201 and the number of turns of the second spring portion 202 are the same, the longitudinal lengths L12 and L22 are equal.

Accordingly, no matter in which direction the conductor 21 is inserted into the tubular body 20 to assemble the contact terminal 2, the functional difference of the contact terminal 2 is further eliminated.

### <5. Modification of tubular body>

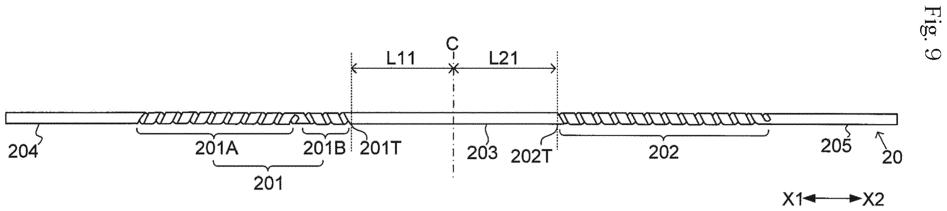

FIG. 9 shows a modification of the tubular body 20 illustrated in FIG. 3. As illustrated in FIG. 9, the winding direction of the second spring portion 202 in the tubular body 20 may be only the second direction. In the example of FIG. 9, the number of turns of the second spring portion 202 is 12.5, which is equal to the number of turns of the first spring portion 201. Therefore, the total number of turns of the winding spring portions whose winding directions are the second direction is 3 + 12.5 = 15.5, and the total number of turns of the winding spring portions whose winding directions are the first direction is 9.5. Accordingly, the tubular body 2 turns in the second direction by the amount of turning corresponding to 15.5 - 9.5 = 6, which is the difference between the total numbers of turns.

The winding direction of the second spring portion 202 may be only the first direction. That is, the winding direction of the second spring portion 202 may be only one of the first direction and the second direction. This makes it easy to adjust turning in one of the first direction and the second direction.

### <6. Others>

While the embodiments of the present invention have been described above, the embodiments can be modified in various ways within the scope of the present invention.

For example, on the tubular body 20, the arrangement of the winding directions of the winding spring portions in the axial direction is not limited to the configuration in FIGS. 3 and 5 and may be configured such that the first direction, the second direction, the first direction, and the second direction are set in the order named, or the second direction, the first direction, the first direction, and the second direction are set in the order named, or the second direction, the first direction, the second direction, and the first direction are set in the order named from the one axial direction X1 side to the other axial direction X2 side.

Furthermore, for example, in the above-described embodiment, the number of conductors is one. However, the present invention is not limited to this, and the number of conductors may be two. In this case, the first conductor is inserted from the second body portion 204 side, and the second conductor is inserted from the third body portion 205 side. The directions in which the first conductor and the second conductor are inserted into the tubular body 20 may be the opposite directions. This improves the assemblability of the contact terminal 2.

### INDUSTRIAL APPLICABILITY

The present invention is applicable to electrical inspections of various inspection targets.

## Claims

1. A tubular body extending in a longitudinal direction and having conductivity, the tubular body comprising:
a first spring portion having a spiral notch formed in a peripheral surface of the tubular body;
a second spring portion having a spiral notch formed in the peripheral surface of the tubular body; and
a first body portion sandwiched between the first spring portion and the second spring portion in the longitudinal direction,
wherein a distance from a longitudinal direction center of the tubular body to a longitudinal direction inner end of the first spring portion is equal to a distance from the longitudinal direction center to a longitudinal direction inner end of the second spring portion,
the number of turns of the first spring portion is equal to the number of turns of the second spring portion, and
the first spring portion includes a first winding spring portion whose winding direction is a first direction and a second winding spring portion whose winding direction is a second direction opposite to the first direction.

2. The tubular body according to claim 1, wherein the first spring portion has a longitudinal length equal to a longitudinal length of the second spring portion.

3. The tubular body according to claim 1 or 2, wherein the second spring portion includes a third winding spring portion whose winding direction is the first direction and a fourth winding spring portion whose winding direction is the second direction.

4. The tubular body according to claim 3, wherein a sum of the number of turns of the first winding spring portion and the number of turns of the third winding spring portion is not equal to a sum of the number of turns of the second winding spring portion and the number of turns of the fourth winding spring portion.

5. The tubular body according to claim 3, wherein a sum of the number of turns of the first winding spring portion and the number of turns of the third winding spring portion is equal to a sum of the number of turns of the second winding spring portion and the number of turns of the fourth winding spring portion.

6. The tubular body according to claim 1 or 2, wherein the winding direction of the second spring portion is only one of the first direction and the second direction.

7. The tubular body according to any one of claims 1 to 6, wherein the notch formed in the first spring portion includes a first spiral notch and a second spiral notch,
the first winding spring portion has the first spiral notch,
the second winding spring portion has the second spiral notch, and
a longitudinal direction inner end portion of the first spiral notch and a longitudinal direction outer end portion of the second spiral notch are disposed at positions separated by 180° around the longitudinal direction.

8. A contact terminal comprising:
a tubular body according to any one of claims 1 to 7 and including a second body portion disposed on an opposite side of the first spring portion to the first body portion; and
a rod-shaped conductor fixed to the second body portion and having conductivity.

9. An inspection jig comprising:
a plurality of the contact terminals according to claim 8; and
a support member that supports the plurality of contact terminals.

10. An inspection apparatus comprising:
the inspection jig according to claim 9; and
an inspection processing unit that performs inspection of an inspection target based on an electrical signal obtained by bringing the contact terminal into contact with an inspection point provided on the inspection target.
